# EUROPEAN PATENT APPLICATION

(11) **EP 4 583 156 A1**
(43) Date of publication of application: **09.07.2025**
(21) Application number: 24150691.4
(22) Date of filing: 08.01.2024
(51) Int. Cl.: H01L 23/00

(54) **A SEMICONDUCTOR PACKAGE SUITABLE FOR HIGH VOLTAGE APPLICATIONS AND METHODS FOR FABRICATING THE SAME**

(71) Applicant: Infineon Technologies AG, 85579 Neubiberg (DE)
(72) Inventor: NEO, Chin Yong, 544625 Singapore (SG); SCHREDL, Juergen, 86415 Mering (DE); ACUESTA, Albert Cruz, 543157 Singapore (SG)
(74) Representative: Lambsdorff & Lange Patentanwälte Partnerschaft mbB

(57) **Abstract**

A semiconductor package comprising a semiconductor die comprising a bond pad (11), an insulating layer (14) covering the bond pad (11), the insulating layer (14) comprising an opening, a polymer layer (13) formed over the insulating layer (14) and covering the sidewalls of the opening in the insulating layer (14), the polymer layer (13) comprising an opening, an electrical conductor (12) comprising a conductive base (12) attached to a part of the bond pad (11) exposed by the insulating layer opening and the polymer layer opening,- the polymer layer (13) comprising an upper segment (13A) and a lower segment (13B) wherein the polymer layer opening is larger in the upper segment (13A) than in the lower segment (13B) .

## Description

### TECHNICAL FIELD

The present disclosure is related to a semiconductor package suitable for high voltage applications and methods for fabricating the semiconductor package.

### BACKGROUND

Certain types of semiconductor chips are characterized by high output voltages at their electrical contact pads. These semiconductor chips include, for example, so-called center-tapped resistor (CTR) chips which can be used to build feedback circuits of amplifiers, in particular Wheatstone Bridge circuits for low noise instrumentation amplifiers. This problem also affects other semiconductor chips, in particular power semiconductor transistor chips, where high electrical voltages can occur at the contact pads. These usually quite small contact pads are then often to be contacted with bonding wires. High-voltage electrical isolation in the immediate vicinity of the contact pads of such semiconductor chips is an increasing challenge for chip manufacturers.

### SUMMARY

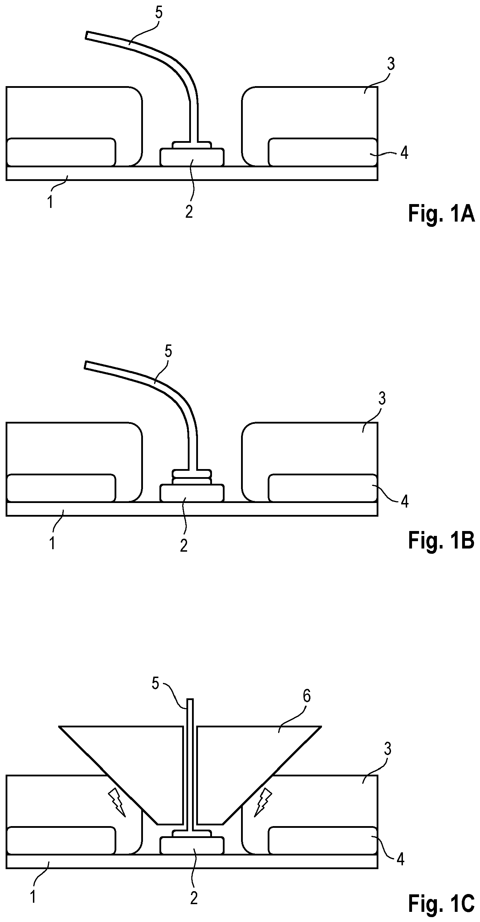

Figs. 1 comprises Fig. 1A to 1C and is intended to illustrate the underlying problem. For the purpose of high-voltage insulation, as described above, a thick layer of a polymer is applied around the bond pad opening. Each one of Figs. 1A to 1C shows a metallization pad 1, an insulating layer 4 disposed on the metallization pad 1 and comprising a first opening, a polymer layer 3 disposed on the insulating layer 2 and comprising a second opening, a conductive base 2 disposed on the metallization pad 1 in the center of the first and second openings, and a bond wire 5 connected with the conductive base 2.

Figs. 1A and 1B show two different kinds of wire bonding. Ball bonding as shown in Fig. 1A is one type of wire bonding, and is the most common way to make the electrical interconnections between a bare silicon die and the lead frame of the package. Ball stitch on bump (BSOB) as shown in Fig. 1B is an alternative choice which is mostly applied in case of more difficult conditions. How the bond wire 5 can be connected with the bond pad 1 in case of very small bond pad openings in the order of 90 µm is shown further below.

Fig. 1C shows the use of a needle-like disposable tool called the capillary vessel 6, through which the wire 5 is fed. The bonding wire is inserted through this capillary vessel 6 and fed into the bond pad opening. As shown in Fig. 1C, an undesirable situation can occur in which the capillary 6 comes into contact with the polymer layer 3. This situation must be avoided, as it can lead to a deterioration in bond wire quality and package reliability risk.

A first aspect of the present disclosure is related to a semiconductor package comprising a semiconductor die comprising a bond pad, an insulating layer covering the bond pad, the insulating layer comprising an opening, a polymer layer formed over the insulating layer and covering the sidewalls of the opening in the insulating layer, the polymer layer comprising an opening, an electrical conductor comprising a conductive base attached to a part of the bond pad exposed by the insulating layer opening and the polymer layer opening, the polymer layer comprising an upper segment and a lower segment wherein the polymer layer opening is larger in the upper segment than in the lower segment.

The described structure of the polymer layer according to the first aspect allows the capillary to be inserted into the bond pad opening without coming into contact with the polymer layer. The polymer layer may comprise a polyimide layer which can easily be structured by means of, for example, photo lithographical structuring.

According to an embodiment of the semiconductor package of the first aspect, the upper segment is thicker than the lower segment.

According to an embodiment of the semiconductor package of the first aspect, the insulating layer comprises one or both of SiO and SiN.

According to an embodiment of the semiconductor package of the first aspect, the polymer layer comprises a thickness in a range from 10 µm to 20 µm.

According to an embodiment of the semiconductor package of the first aspect, the semiconductor package further comprises a bond wire connected to the conductive base. The way of bonding the bond wire may comprise a ball bond or ball stitch on bump (BSOB).

According to an embodiment of the semiconductor package of the first aspect, a portion of the lower segment of the polymer layer covers the top of the insulating layer.

According to an embodiment of the semiconductor package of the first aspect, the conductive base is a ball bump.

According to an embodiment of the semiconductor package of the first aspect, the polymer layer is made of a photosensitive material.

A second aspect of the present disclosure is related to a method for fabricating a semiconductor package, the method comprising providing a semiconductor die comprising a bond pad and forming an insulating layer covering the bond pad, the insulating layer comprising an opening, forming a polymer layer above the bond pad and over the insulating layer, the polymer layer comprising an opening and an upper segment and a lower segment wherein the polymer layer opening is larger in the upper segment than in the lower segment, and attaching an electrical conductor comprising a conductive base to a part of the bond pad exposed by the insulating layer opening and the polymer layer opening.

According to an embodiment of the method of the second aspect, forming the polymer layer comprises applying a polymer layer, and removing the polymer layer in the opening. According to an example thereof, removing the polymer layer in the opening comprises photo lithographical structuring.

According to an embodiment of the method of the second aspect, the insulating layer comprises one or both of SiO and SiN.

According to an embodiment of the method of the second aspect, the method further comprises attaching the semiconductor die to a leadframe and applying an encapsulant that covers at least a portion of the semiconductor die, polymer layer and leadframe. In some implementations, the method further comprises applying an adhesion promoter layer to the semiconductor die, the polymer layer and the leadframe before applying the encapsulant.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 comprises Fig. 1A to 1C and shows cross-sectional views to illustrate ball bonding (A), ball stitch on bump (BSOP) bonding (B), and use of a capillary vessel for bonding (C).
Fig. 2 comprises Fig. 2A and 2B and shows a cross-sectional view of an example of an electrical contact structure (A) and a cross-section illustrating the process of connecting the bond wire to the conductive base by using a capillary vessel.
Fig. 3 comprises Figs. 3A to 3C and shows a cross-sectional view to illustrate a first variant for fabricating the stepped polymer layer in the form of a one-step process (A), a second variant for fabricating the stepped polymer layer in the form of a two-step process (B), and a top view on the stepped polymer layer fabricated by either one of the first and second variants (C).
Fig. 4 shows a flow diagram of an example of a method for fabricating a semiconductor chip.
Fig. 5 shows pictorial representations 5.1 to 5.6 illustrating an example of a method for fabricating a semiconductor chip.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

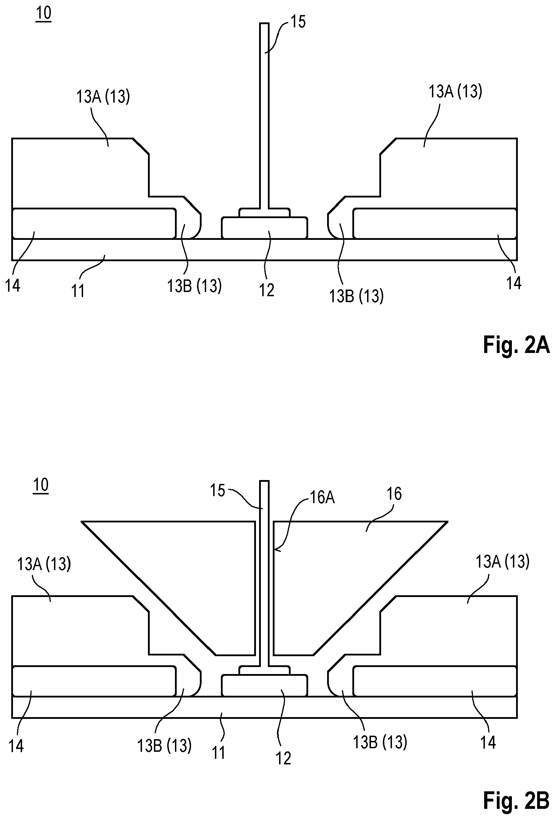

Fig. 2 comprises Fig. 2A and 2B and shows a cross-sectional view of an example of an electrical contact structure (A) and a cross-section illustrating the process of connecting the bond wire to the conductive base by using a capillary vessel.

More specifically, Fig. 1A shows an electrical contact structure 10 which can be part of a semiconductor package. The electrical contact structure 10 comprises a contact pad 11 and a conductive base 12 disposed on the contact pad 11. Both the contact pad 11 and the conductive base 12 can, for example, be made of copper or a copper alloy. The electrical contact structure 10 further comprises a polymer layer 13 disposed above the contact pad 11, the polymer layer 13 comprising an opening, wherein the conductive base 12 being disposed in the opening. The polymer layer 13 comprises an upper layer 13A and a lower layer 13B wherein the opening is larger in the upper layer 13A than in the lower layer 13B.

The electrical contact structure 10 may further comprise an insulating layer 14 disposed on the contact pad 11. The insulating layer 14 may comprise one or both of SiO and SiN. The insulating layer 14 comprises an opening which is larger than the opening of the lower layer 13B of the polymer layer 13 so that side walls of the insulating layer 14 are covered by the polymer layer 13.

The polymer layer 13 may comprise a polyimide layer 13. Furthermore the polymer layer may comprise a thickness in a range from 10 µm to 20 µm.

The electrical contact structure 10 may further comprise a bond wire 15. Fig. 1B illustrates the process of connecting the bond wire 15 to the conductive base 12. For this purpose, a capillary vessel 16 is inserted into the opening of the electrical contact structure 10. The capillary vessel 16 as shown usually comprises a shape of a truncated cone, the short end of which is brought into the immediate vicinity of the surface of the conductive base 12. The capillary vessel 16 has a central hole 16A through which the bonding wire 15 can be inserted and finally bonded to the conductive base in a manner known per se. The stepped shape of the polymer layer 13 with different opening sizes of the upper layer 13A and the lower layer 13B ensures that the capillary vessel 16 does not come into contact with the polymer layer 13.

The polymer layer 13 together with its upper and lower sublayers 13A and 13B and the insulating layer 14 enclose the bond opening and the conductive base 12, for example, in an annular shape, as illustrated in Fig. 2C.

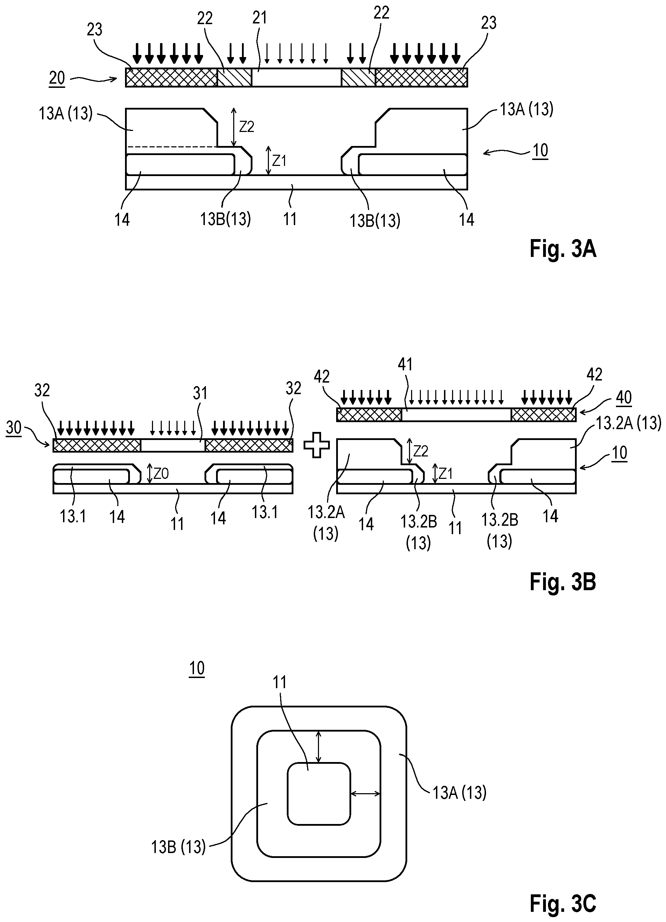

Fig. 3 comprises Figs. 3A to 3C and shows a cross-sectional view to illustrate a first variant for fabricating the stepped polymer layer in the form of a one-step process (A), a second variant for fabricating the stepped polymer layer in the form of a two-step process (B), and a top view on the stepped polymer layer fabricated by either one of the first and second variants (C).

More specifically, both variants illustrated in Fig. 3A and 3B implement the use of photo-structurable polyimides. These polyimides can be lithographically structured in a similar way as a photoresist. In both variants, the type of polyimide is selected so that its mode of action corresponds to that of a positive photoresist. A positive photoresist is a type of photoresist in which a portion is exposed to light, typically UV light, and becomes soluble to the photoresist developer. The unexposed portion of the photoresist remains insoluble in the photoresist developer. In both variants, in a first step a polyimide layer is applied over the entire surface of the die pad and the insulator layer. In a second step, an exposure mask with areas of different light transmittance is then placed above the electrical contact structure, followed by an exposure step.

Fig. 3A shows a variant which implements an exposure mask 20 comprising a first unmasked area 21 comprising 100% light transmittance, a ring-shaped second area 22 comprising a light transmittance of w% with 0 < w < 100, and a third ring-shaped masked area 23 comprising 0% light transmittance. A polymer layer 13 is deposited on the metallization pad 11 and the insulating layer 14. After exposure, the assembly is fed to a photoresist developer. As a result, a first portion of the polymer layer underneath the first unmasked area 21 is fully removed, a second ring-shaped portion 13B of the polymer layer underneath the second ring-shaped area 22 is partly removed, and a third ring-shaped portion 13A of the polymer layer remains fully intact. The value w determines how much material is removed from the second ring-shaped section 13B of the polymer layer from the top, and thus the height Z1 of the unremoved polymer layer at the bottom, and thus also the height Z2 of the third ring-shaped section (13A) of the polymer layer. The total height Z1 + Z2 corresponds to the height of the initially deposited polymer layer.

Fig. 3B shows another variant in which two exposure steps are carried out. As shown in the left partial picture a first polymer layer 13.1 is initially deposited on the metallization pad 11 and the insulating layer. This first polymer layer 13.1 may for example be of a greater thickness to the one mask variant in Fig. 3A in order to account for thinning down during a second exposure and development step, i.e. Z0 has to be thicker than Z1. A first exposure step which implements an exposure mask 30 comprising a first unmasked area 31 comprising 100% light transmittance, and a ring-shaped second area 32 comprising 0% light transmittance is carried out. After exposure, the assembly is fed to a photoresist developer. As a result, a first portion of the polymer layer underneath the first unmasked area 31 is fully removed, and a second ring-shaped portion of the polymer layer 13.1 remains fully intact. As shown in the right partial image, a second relatively thick polymer layer 13.2 having a height Z2 over the first polymer layer 13.1 is deposited and in a second exposure step an exposure mask 40 comprising a first unmasked area 41 comprising 100% light transmittance, and a ring-shaped second area 42 comprising 0% light transmittance is used. In a subsequent developing step an inner portion of the second polymer layer 13.2 is removed resulting in a step-like structure which can be similar or equal like the one shown in Fig. 3A comprising a first upper ring-shaped portion 13.2A and a second lower ring-shaped portion 13.2B.

In general, both variants as shown in Fig. 3A and 3B should be carried out in such a way that the height Z1 of the lower polymer layer should be smaller than the height Z2 of the upper polymer layer.

In the following, it is shown how the process of manufacturing an electrical contact structure described above can be integrated into a process for manufacturing a semiconductor chip.

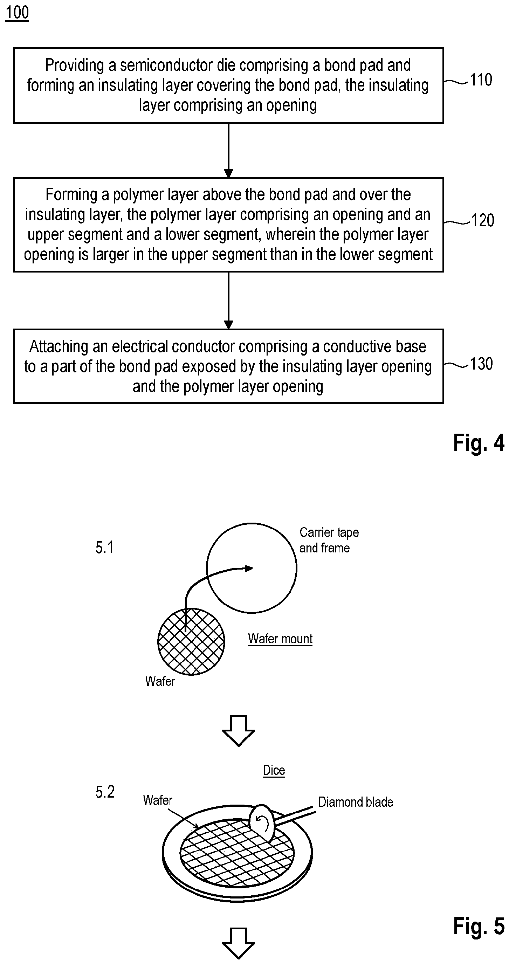

Fig. 4 shows a flow diagram of an example of a method for fabricating a semiconductor package.

The method 100 as shown in Fig. 4 comprises providing a semiconductor die comprising a bond pad and forming an insulating layer (14) covering the bond pad (11), the insulating layer comprising an opening (110), forming a polymer layer above the bond pad and over the insulating layer, the polymer layer comprising an opening and an upper segment and a lower segment (13B) wherein the polymer layer opening is larger in the upper segment than in the lower segment (120), and attaching an electrical conductor comprising a conductive base to a part of the bond pad exposed by the insulating layer opening and the polymer layer opening (130).

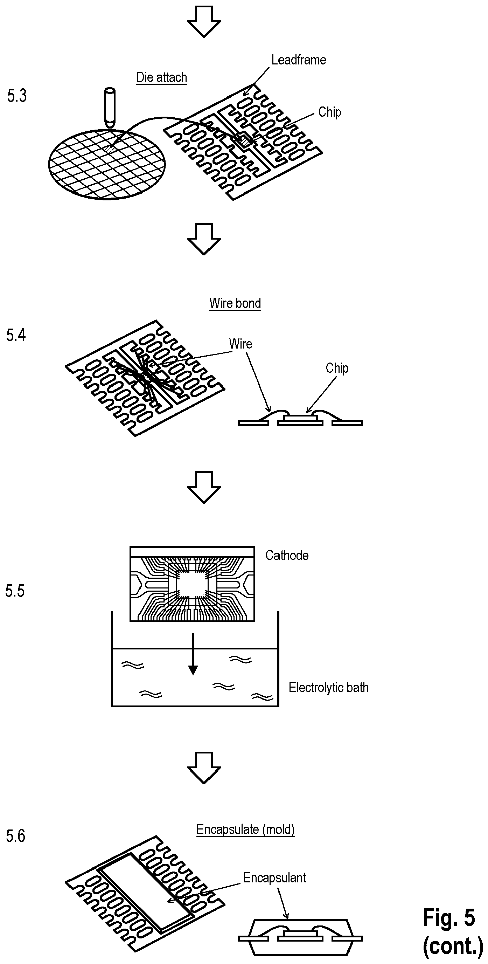

Fig. 5 shows pictorial representations 5.1 to 5.6 illustrating an example of a method for fabricating a semiconductor chip.

According to Fig. 5.1 a wafer is provided which comprises a plurality of pre-fabricated semiconductor dies, each one of the semiconductor dies comprising two or more contact pads on an upper surface thereof. Individual or all contact pads of the semi-conductor dies are each provided with an electrical contact structure as described above with reference to Figs. 2 and 3. The wafer is mounted on a carrier tape and frame.

According to Fig. 5.2 the individual semiconductor dies are separated from each other on the carrier tape by sawing with a diamond blade.

According to Fig. 5.3, a lead frame is provided which comprises a die pad and a plurality of leads. It is shown how a semiconductor die of the plurality of semiconductor dies is detached from the carrier tape and applied to the pad of the lead frame.

According to Fig. 5.4, the bond pads of the semiconductor die are connected to the leads by bond wire. This includes the earlier described process of attaching an electrical conductor (12) comprising a conductive base (12) to a part of the bond pad (11) exposed by the insulating layer opening and the polymer layer opening as shown in Fig. 2B.

According to Fig. 5.5, the complete assembly is covered with an adhesion promoter layer. The purpose of the adhesion promoter layer is to improve adhesion between the subsequently applied encapsulant and the lead frame. The deposition process may be done by electrolysis. For this purpose, the entire assembly is connected with a metallic cathode and immersed in an electrolytic bath. The adhesion promotion layer may be deposited by an electrolytic plating process using a commercially available electrolytic plating bath..

The application of the adhesion promoter layer makes it necessary to form the polymer layer during the manufacture of the electrical contact structures of the contact pads in Fig. 5.1 in such a way that it also covers the inner side walls of the insulating layer. For example, in the case of an unprotected insulating layer such as an SiN/SiO layer, the acidic chemical contained in the electrolyte could seep through the SiN/SiO layer and corrode the metallic contact pad.

According to Fig. 5.6, an encapsulant is applied to the semiconductor die and the outer portions of the leadframe are cut off to form an individual semiconductor chip package. Applying the encapsulant can be done, for example, by compression molding or transfer molding.

### EXAMPLES

In the following specific examples of the present disclosure are described.

Example 1 is a semiconductor package comprising a semiconductor die comprising a bond pad, an insulating layer covering the bond pad, the insulating layer comprising an opening, a polymer layer formed over the insulating layer and covering the sidewalls of the opening in the insulating layer, the polymer layer comprising an opening, an electrical conductor comprising a conductive base attached to a part of the bond pad exposed by the insulating layer opening and the polymer layer opening, the polymer layer comprising an upper segment and a lower segment wherein the polymer layer opening is larger in the upper segment than in the lower segment.

Example 2 is a semiconductor package according to Example 1, wherein the upper segment is thicker than the lower segment.

Example 3 is a semiconductor package according to Example 1 or 2, wherein the insulating layer comprises one or both of SiO and SiN.

Example 4 is a semiconductor package according to any one of the preceding Examples, wherein the polymer layer comprises a polyimide layer.

Example 5 is a semiconductor package according to any one of the preceding Examples, wherein the polymer layer comprises a thickness in a range from 10 µm to 20 µm.

Example 6 is a semiconductor package according to any one of the preceding Examples, further comprising a bond wire connected to the conductive base.

Example 7 is a semiconductor package according to any one of the preceding Examples, wherein a portion of the lower segment of the polymer layer covers the top of the insulating layer.

Example 8 is a semiconductor package according to any one of the preceding Examples, wherein the conductive base is a ball bump.

Example 9 is a semiconductor package according to any one of the preceding Examples, wherein the polymer layer is made of a photosensitive material.

Example 10 is a method for fabricating a semiconductor package, the method comprising providing a semiconductor die comprising a bond pad and forming an insulating layer covering the bond pad, the insulating layer comprising an opening, forming a polymer layer above the bond pad and over the insulating layer, the polymer layer comprising an opening and an upper segment and a lower segment wherein the polymer layer opening is larger in the upper segment than in the lower segment, and attaching an electrical conductor comprising a conductive base to a part of the bond pad exposed by the insulating layer opening and the polymer layer opening.

Example 11 is a method according to Example 10, wherein forming the polymer layer comprises applying a polymer layer, and removing the polymer layer in the opening.

Example 12 is a method according to Example 11, wherein removing the polymer layer in the opening comprises photo lithographical structuring.

Example 13 is a method according to any one of Examples 10 to 12, wherein the insulating layer comprises one or both of SiO and SiN.

Example 14 is a method according to any one of Examples 10 to 13, further comprising attaching the semiconductor die to a leadframe and applying an encapsulant that covers at least a portion of the semiconductor die, the polymer layer and the leadframe.

Example 15 is a method according to Example 14, further comprising applying an adhesion promoter layer to the semiconductor die, the polymer layer and the leadframe before applying the encapsulant.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package comprising
- a semiconductor die comprising a bond pad (11);
- an insulating layer (14) covering the bond pad (11), the insulating layer (14) comprising an opening;
- a polymer layer (13) formed over the insulating layer (14) and covering the sidewalls of the opening in the insulating layer (14), the polymer layer (13) comprising an opening;
- an electrical conductor (12) comprising a conductive base (12) attached to a part of the bond pad (11) exposed by the insulating layer opening and the polymer layer opening;
- the polymer layer (13) comprising an upper segment (13A) and a lower segment (13B) wherein the polymer layer opening is larger in the upper segment (13A) than in the lower segment (13B).

2. The semiconductor package according to claim 1, wherein the upper segment (13A) is thicker than the lower segment (13B) .

3. The semiconductor package according to claim 1 or 2, wherein
the insulating layer (14) comprises one or both of SiO and SiN.

4. The semiconductor package according to any one of the preceding claims, wherein
the polymer layer (13) comprises a polyimide layer (13).

5. The semiconductor package according to any one of the preceding claims, wherein
the polymer layer (13) comprises a thickness in a range from 10 µm to 20 µm.

6. The semiconductor package according to any one of the preceding claims, further comprising
a bond wire (15) connected to the conductive base (12).

7. The semiconductor package according to any one of the preceding claims, wherein
a portion of the lower segment of the polymer layer (13) covers the top of the insulating layer (14).

8. The semiconductor package according to any one of the preceding claims, wherein
the conductive base (12) is a ball bump.

9. The semiconductor package according to any one of the preceding claims, wherein
the polymer layer (13) is made of a photosensitive material.

10. A method (100) for fabricating a semiconductor package, the method comprising
providing a semiconductor die comprising a bond pad and forming an insulating layer (14) covering the bond pad (11), the insulating layer comprising an opening (110);
forming a polymer layer above the bond pad and over the insulating layer, the polymer layer comprising an opening and an upper segment (13A) and a lower segment (13B) wherein the polymer layer opening is larger in the upper segment than in the lower segment (120); and
attaching an electrical conductor comprising a conductive base to a part of the bond pad exposed by the insulating layer opening and the polymer layer opening (130).

11. The method according to claim 10, wherein
forming the polymer layer comprises
applying a polymer layer; and
removing the polymer layer in the opening.

12. The method according to claim 11, wherein
removing the polymer layer in the opening comprises photo lithographical structuring.

13. The method according to any one of claims 10 to 12, wherein
the insulating layer comprises one or both of SiO and SiN.

14. The method according to any one of claims 10 to 13, further comprising attaching the semiconductor die to a leadframe and applying an encapsulant that covers at least a portion of the semiconductor die, the polymer layer and the leadframe.

15. The method according to claim 14, further comprising applying an adhesion promoter layer to the semiconductor die, the polymer layer and the leadframe before applying the encapsulant.
